(19) Europäisches Patentamt
European Patent Office
Office européen des brevets

(11) **EP 3 035 455 A1**

(12) **DEMANDE DE BREVET EUROPEEN**

(43) Date de publication:
**22.06.2016 Bulletin 2016/25**

(51) Int Cl.:
**H01S 5/026** $^{(2006.01)}$   **H01S 5/0625** $^{(2006.01)}$
**H01S 5/50** $^{(2006.01)}$

(21) Numéro de dépôt: **14307056.3**

(22) Date de dépôt: **16.12.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(71) Demandeur: **ALCATEL LUCENT**
**92100 Boulogne-Billancourt (FR)**

(72) Inventeurs:
• **De Valicourt, Guilhem**
  **91620 NOZAY (FR)**
• **Ghazisaeidi, Amirhossein**
  **91620 NOZAY (FR)**

(74) Mandataire: **Berthier, Karine et al**
**Alcatel-Lucent International**
**148/152, route de la Reine**
**92100 Boulogne-Billancourt (FR)**

(54) **Procédé de pilotage d'un amplificateur optique à semiconducteur SOA multisection**

(57) Un procédé permet de pilotage des courants injectés simultanément respectivement dans chaque section d'un amplificateur optique à semiconducteur SOA qui comporte au moins une section d'amplification dans laquelle est injecté un courant d'amplification $I_1$ et au moins une section de modulation dans laquelle est injecté un courant de modulation $I_2$,

Le courant d'amplification $I_1$ et le courant de modulation $I_2$ sont reliés par la relation : $\delta\tilde{H}_2(\omega) = -\eta\delta\tilde{H}_1(\omega)$, dans laquelle $\tilde{H}_1(\omega)$ et $\tilde{H}_2(\omega)$ sont les transformées de Fourier des exposants instantanés du gain de petit-signal $\delta\tilde{h}_1(t)$ et $\delta\tilde{h}_{21}(t)$ respectivement, et $\eta$ est un coefficient caractérisant le rapport d'amplitude entre ces transformées de Fourier.

Les transformées de Fourier sont reliées aux modulations du courant d'amplification $I_1$ et du courant de modulation $I_2$ respectivement par la relation : $\delta\tilde{h}_i(t) = \delta I_i(t)$..

## FIG. 5

EP 3 035 455 A1

**Description**

DOMAINE

La présente invention se rapporte au domaine des réseaux d'accès de télécommunication, en particulier les réseaux optiques passifs dit PON (pour « Passive Optical Network » en anglais) utilisant la technique de multiplexage en longueur d'onde dite WDM (pour « Wavelength-Division Multiplexing » en anglais) ou ayant une architecture hybride WDM/TDM de la technique WDM avec la technique de multiplexage temporel dite TDM (pour « Time Division Multiplexing » en anglais).

ARRIERE PLAN

Des réseaux de télécommunication de plus en plus grande capacité sont nécessaires pour satisfaire la pénétration continue de l'Internet, et pour supporter des applications exigeantes telles que la télévision haute définition, la vidéo à la demande, les jeux en ligne, etc.... Dans les réseaux d'accès, la technologie « Fibre-jusqu'à-l'immeuble » ou « Fibre-jusqu'à-la-maison » dite FTTP (pour « Fiber-to-the-premises » en anglais) est considérée comme la principale solution pour satisfaire la demande.

Aujourd'hui la technique de multiplexage temporel TDM est largement utilisée dans les réseaux PON, dénommés réseaux TDM-PON. La technique TDM est destinée à servir plusieurs utilisateurs en utilisant deux canaux de longueur d'onde respectivement pour le trafic montant et pour le trafic descendant.

Pour les réseaux d'accès de prochaine génération, une meilleure aptitude à évoluer et une capacité plus élevée pourraient être obtenues en utilisant la technique de multiplexage en longueur d'onde WDM dans les réseaux optiques passifs PON, alors dénommés réseaux WDM-PON. Cependant, le coût de ces réseaux WDM-PON et la compatibilité avec les réseaux TDM-PON existants est toujours un problème. En raison du coût élevé des composants WDM, des architectures hybrides dites WDM/TDM sont à l'étude pour les réseaux d'accès de prochaine génération.

Des unités de réseau optiques ONU (pour « Optical Network Unit » en anglais) incolores, c'est-à-dire aptes à accepter un canal de n'importe quelle longueur d'onde, sont alors essentielles pour assurer le déploiement de la technologie WDM dans le réseau d'accès. Un élément-clé permettant l'utilisation des unités ONU incolores est un amplificateur optique à semiconducteur SOA (pour « Semiconductor Optical Amplifier » en anglais) ou un amplificateur optique à semiconducteur réfléchissant RSOA (pour « Reflective Semiconductor Optical Amplifier » en anglais), qui est un composant intégrable de faible coût capable de faire à la fois la modulation incolore et l'amplification optique simultanément. Le RSOA est un composant plus compact que le SOA en raison d'une amplification qui s'effectue dans un sens et dans le sens inverse. Le RSOA est aussi un composant de moindre coût car il ne comporte qu'un seul connecteur fibré.

Le RSOA a été considéré comme un transmetteur prometteur pour la prochaine génération de réseaux WDM-PON. Ces composants RSOA sont composés d'un milieu de gain entre une face non-réfléchissante et une face réfléchissante. Le gain est obtenu à partir de l'émission stimulée par injection de courant électrique dans les couches actives. Lorsqu'un signal optique continu est injecté dans le RSOA, la puissance optique recueillie à la sortie dépend de la valeur du courant électrique injecté. Par conséquent, le RSOA peut effectuer une conversion électrique à optique (E/O), la longueur d'onde de sortie étant identique à la porteuse optique injectée. Un tel composant RSOA peut être utilisé comme un modulateur distant pour les réseaux d'accès optique.

Un premier réseau PON de type hybride basé sur des SOA a été mis sur le marché. Cependant, un problème subsiste qui est dû à la bande passante de modulation du composant SOA qui limite fortement le débit des données transmises. Jusqu'à présent, des modulations avec une qualité acceptable de signal peuvent être obtenues jusqu'à 2,5 Gbit/s sans égalisation électronique. Une recherche active sur l'amélioration de la bande passante de modulation a permis d'atteindre une bande passante en modulation petit-signal à 7 GHz avec des dispositifs à deux sections, mais un tel résultat n'a pu être obtenu en modulation large-signal.

Le fonctionnement d'un SOA à 10 Gbit/s est donc toujours un défi. Plusieurs solutions ont été proposées pour atteindre un débit de données supérieur à 10 Gbit/s, comme le fonctionnement avec une pré-amplification et une égalisation électronique, la technique de multiplexage par répartition en fréquences orthogonales OFDM (pour « Orthogonal Frequency-Division Multiplexing) en anglais) ou un filtrage électronique. Toutes ces techniques ont besoin de matériel supplémentaire coûteux qui n'est pas conforme aux exigences d'un réseau d'accès. En outre dans ces différents cas, la bande passante de modulation du SOA est limité à 2 GHz.

Une autre solution consiste à diminuer la durée de vie de la porteuse afin d'augmenter la bande passante de modulation au-delà de 3 GHz. Un SOA plus long est plus rapide et il peut être poussé pour opérer de justesse jusqu'à 10 Gb/s ; mais aller au-delà de 10 Gb/s nécessite encore d'augmenter la bande passante de modulation. Une amélioration modérée portant sur la bande passante de modulation ne permet pas d'atteindre une performance compatible avec les besoins des réseaux d'accès, et une amélioration plus importante de la bande passante, jusqu'à 7 GHz en utilisant des composants à deux sections comme mentionné ci-dessus, n'est pas non plus utile car les conditions de fonctionnement changent avec la modulation large-signal. Une transmission avec un débit de données supérieur à 10 Gbits/s n'est alors pas possible non plus.

RESUME

Jusqu'à présent, un laser accordable reste cher. Un tel dispositif est principalement utilisé dans le réseau métropolitain longue-distance, et son cout limite son déploiement dans d'autre segment de réseaux. Un SOA apparait donc comme une alternative parfaite en tant que dispositif incolore pour une ONU, mais il est encore limité en termes de performances.

Le but est d'éliminer les inconvénients de l'art antérieur, et en particulier de proposer un procédé pour faire fonctionner un SOA multisection en lui permettant d'atteindre un débit de données égal ou supérieur à 10 Gbit/s, de manière à s'appliquer à la prochaine génération de réseaux 10G-PON, tout en conservant une large bande passante de modulation, même sous modulation large-signal, et sans introduction de matériel coûteux.

L'objet de la présente invention est un procédé de pilotage des courants injectés simultanément respectivement dans chaque section d'un amplificateur optique à semiconducteur SOA comportant au moins une section d'amplification dans laquelle est injecté un courant d'amplification $I_1$ et au moins une section de modulation dans laquelle est injecté un courant de modulation $I_2$.

Le courant d'amplification $I_1$ et le courant de modulation $I_2$ sont reliés par la relation :

$$\delta\tilde{H}_2(\omega) = -\eta\,\delta\tilde{H}_1(\omega)$$

dans laquelle $\tilde{H}_1(\omega)$ et $\tilde{H}_2(\omega)$ sont les transformées de Fourier des exposants instantanés du gain de petit-signal $\delta\tilde{h}_1(t)$ et $\delta\tilde{h}_2(t)$ respectivement, et $\eta$ est un coefficient caractérisant le rapport d'amplitude entre ces transformées de Fourier, les transformées de Fourier étant reliées aux modulations du courant d'amplification $I_1$ et du courant de modulation $I_2$ respectivement par la relation : $\delta\tilde{h}_i(t) = \delta I_i(t)$.

L'idée de base de l'invention consiste à utiliser la réponse sous une modulation électrique d'un SOA multisection (apparition d'une résonnance) sous différents régimes de fonctionnement afin de cumuler les différents effets et d'augmenter la bande passante de modulation. Le procédé proposé permet de piloter les courants injectés simultanément respectivement dans chacune des sections afin d'être en mesure de transmettre des données sous modulation large-signal, en améliorant la bande passante globale de modulation large-signal. Le coefficient $\eta$ est déterminé pour optimiser la bande de modulation pour les différents couples de courants $I_1$ et $I_2$.

L'invention a aussi pour objet un amplificateur optique à semiconducteur comportant au moins une section d'amplification dans laquelle est injecté un courant d'amplification $I_1$ et au moins une section de modulation dans laquelle est injecté un courant de modulation $I_2$, dans lequel la section de modulation est plus courte que la section d'amplification du signal optique modulé.

Selon un aspect, l'électrode de la section de modulation a une surface moindre que l'électrode de la section d'amplification.

Selon un autre aspect, l'amplificateur optique à semiconducteur est un amplificateur optique à semiconducteur réfléchissant.

Dans la description qui suit, le terme « amplificateur optique à semiconducteur SOA » inclut le cas particulier d'un amplificateur optique à semiconducteur réfléchissant RSOA. Bien que le mode de réalisation décrit comporte un RSOA car c'est le composant le plus utilisé dans les réseaux d'accès aujourd'hui, il pourrait tout aussi bien comporter un SOA, et ce qui est décrit pour un RSOA pourrait tout aussi bien s'appliquer à un SOA.

Afin de suivre la technologie 10G-PON, des ONU incolores fonctionnant à 10 Gbit/s sont nécessaires, mais en même temps le coût doit être maintenue aussi faible que possible. La présente invention présente à la fois les avantages de l'utilisation des composants RSOA tout en augmentant les performances et sans utiliser un matériel ou un logiciel supplémentaire coûteux.

L'invention permet d'obtenir des ONU incolores à faible coût sur la base de composants RSOA pour fonctionner à débit de données élevé. Elle pourra être utilisée pour la prochaine génération de réseaux d'accès basé sur la technique WDM avec un débit de données allant au moins jusqu'à 10 Gbit/s.

BREVE DESCRIPTION

D'autres caractéristiques et avantages apparaîtront à la lecture de la description qui suit !d'un mode de réalisation particulier, donné bien entendu à titre illustratif et non limitatif, et dans le dessin annexé sur lequel

- la figure 1 illustre le principe de l'architecture d'un réseau PON basé sur un RSOA,
- la figure 2 illustre schématiquement le principe de fonctionnement d'un RSOA,
- la figure 3 illustre schématiquement un RSOA monolithiquement intégré,
- la figure 4 illustre schématiquement un SOA multi-étage,
- la figure 5 illustre schématiquement un RSOA à deux sections ,
- la figure 6 illustre la réponse E/O sous une modulation électrique des sections d'un RSOA à deux sections, le gain G en dB est donné en ordonnée et en abscisse la fréquence F en GHz,
- la figure 7 illustre la comparaison des réponses E/O d'un SOA classique à une seule section et d'un SOA à deux sections sous une modulation petit-signal en fonction de la fréquence, la réponse E/O R en dBm est donné en ordonnée et en abscisse la fréquence F en GHz,
- les figures 8a à 8c illustrent la réponse E/O sous une modulation électrique d'un SOA à deux sections en fonction de la fréquence, la réponse E/O R en dBm est donné en ordonnée et en abscisse la fréquence F en GHz.

DESCRIPTION DETAILLEE

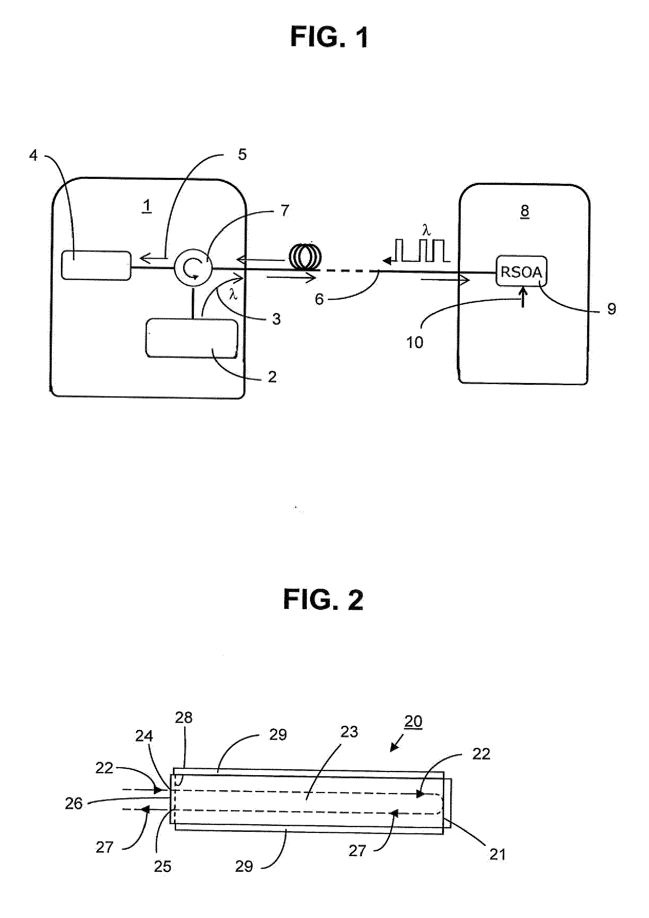

Une architecture de réseau PON basé sur un RSOA est illustrée sur la figure 1, en particulier la partie amont d'une liaison utilisant un RSOA c'est-à-dire la partie relative aux informations envoyées par l'abonné à l'opérateur du réseau.

Un réseau PON comporte un office central **1**. L'office central **1** comprend une source émettrice **2,** par exemple un laser, émettant un signal optique **3** associé à une longueur d'onde λ particulière. Ce signal optique **3** véhicule dans le réseau des données provenant des différents abonnés connectés, selon le principe du multiplexage en longueur d'onde WDM. L'office central **1** comporte également un module de réception **4** chargé de recevoir des signaux optiques **5** émis par les équipements de terminaison de ligne.

Une première extrémité d'une fibre optique **6** est connectée à la sortie de l'office central **1**. La source émettrice **2** est utilisée pour envoyer de la lumière continue à l'abonné par l'intermédiaire d'un circulateur optique **7.** Le circulateur optique **7** permet de séparer les signaux optiques **5** transmis dans le sens montant, c'est-à-dire depuis un équipement de communication situé du côté utilisateur vers l'office central **1,** et les signaux optiques **3** transmis dans le sens descendant, c'est-à-dire depuis l'office central **1** vers au moins un équipement de communication situé du côté utilisateur. Le signal optique **3** émis se propage le long de la fibre optique **6,** jusqu'à une ONU **8**. De son côté, le signal optique **5,** à la fois amplifié et modulé par le RSOA **9,** est chargé de transmettre par la liaison de transmission montante les données **10** venant de l'abonné vers l'office central **1.**

La figure 2 illustre schématiquement le principe d'un amplificateur optique à semiconducteur réfléchissant RSOA.

On rappelle qu'un RSOA est un amplificateur optique à semiconducteur (ou SOA) qui comprend d'une part une première face et une seconde face opposée à la première et d'autre part des moyens d'amplification de la puissance optique des signaux optiques à traiter, et le cas échéant des moyens de modulation les signaux optiques à traiter. La première face est munie d'un premier port permettant la réception par le RSOA de signaux optiques à traiter et d'un deuxième port permettant la transmission par le RSOA des signaux optiques traités. La deuxième face est destinée à réfléchir les signaux optiques depuis le premier port vers le deuxième port.

Dans le composant RSOA **20,** illustré sur la figure 2, une surface réfléchissante **21** est disposée à l'extrémité du guide d'onde opposée à l'entrée du RSOA de manière à réfléchir la lumière incidente **22** vers la zone d'amplification **23**. Par conséquent, le port d'entrée **24** et le port de sortie **25** du RSOA **20** se trouve du même côté, sur la même face **26** du RSOA **20**. Le RSOA **20** peut ainsi être plus compact en raison de la double amplification du signal, à la fois dans le sens de propagation de la lumière incidente **22** et dans le sens inverse qui est le sens de propagation de la lumière réfléchie **27.** Une couche de revêtement antireflet **28** a été déposée sur la face avant **26** portant le port d'entrée **24** et le port de sortie **25** du RSOA **20**. Des électrodes **29** sont formées au-dessus et en-dessous de la zone d'amplification **23** afin de permettre son fonctionnement.

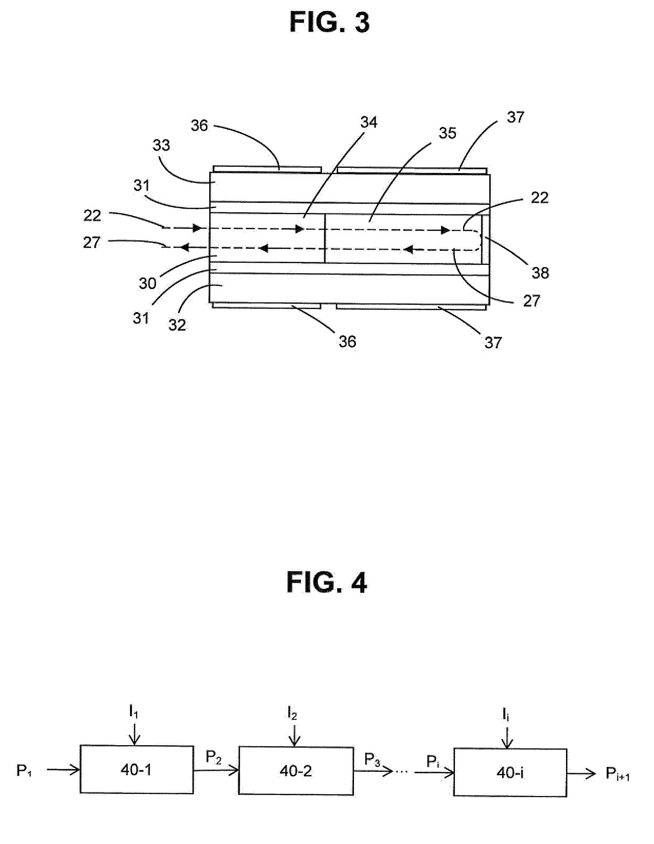

Un RSOA, comme illustré sur la figure 3, est le plus souvent un composant électro-optique monolithique en semi-conducteur comprenant un guide d'onde optique actif configuré pour guider un signal optique. Le guide d'onde optique actif, qui comprend la couche guidante **30** située entre deux couches de confinement **31** de InGaAsP Q1.17. La couche guidante **30** de InGaAsP Q1.15 du RSOA a été fabriquée sur un substrat InP par épitaxie par jets moléculaires MBE (pour « Molecular Beam Epitaxy » en anglais) et entourée de couches de confinement **31** de InGaAsP Q1.17. Le guide d'onde optique actif se présente sous la forme d'un ruban enterré dans une matrice **32** de InP dopé p grâce à une reprise d'épitaxie. L'ensemble est recouvert d'une couche **33** de InP dopé n.

Le guide d'ondes optique actif traverse une première section **34** et une deuxième section **35** du RSOA. Dans le cas présent, une double structure de coeur a été choisie avec l'intégration des guides d'ondes actif et passif par un biseau à l'entrée du RSOA, ce qui permet d'améliorer le couplage avec un guide d'onde optique transportant le signal optique entrant.

Un RSOA à deux sections comprend une première section **34** où un courant de polarisation est appliqué par une première paire d'électrodes **36** Cette section **34** assure une amplification du signal optique confiné dans la couche guidante **30**. Le RSOA comprend en outre une deuxième section **35** où un courant continu modulé est appliqué à une deuxième paire d'électrodes **37** située à proximité de la surface réfléchissante **38**. Dans un RSOA à deux sections, la deuxième paire d'électrodes **37** de grande surface offre une plus grande largeur de bande passante électro-optique E/O pour une même modulation électrique. Enfin le RSOA comprend une section de réflexion qui peut être réalisée par une région à propriété fortement réfléchissante, telle qu'une surface réfléchissante **38,** et/ou par un intervalle d'air.

Ainsi le signal optique renvoyé vers le port de sortie du RSOA est un signal optique modulé et amplifié. Ce signal optique modulé et amplifié peut être transmis sur une fibre optique. Un RSOA à deux sections peut notamment être utilisé dans les réseaux d'accès, en particulier les réseaux RoF (pour « Radio-On-Fiber » en anglais) comme décrit par exemple dans le document EP-2 501 000 incorporé ici par référence.

Sur la figure 4, on a illustré schématiquement une architecture multisection comportant des SOA **40-1, 40-2,..., 40-i** en cascade. Cette cascade de SOA est utilisée pour modéliser un SOA en le divisant en plusieurs sous-sections.

Le SOA **40-1** reçoit la puissance d'entrée optique $P_1$ et le courant électrique $I_1$, et délivre en sortie la puissance optique $P_2$. De même, le SOA **40-i** reçoit la puissance d'entrée optique $P_i$ et le courant électrique $I_i$, et délivre en sortie la puissance optique $P_{i+1}$. Les équations suivantes régissent l'amplification optique du SOA **40-i** :

$$\tau_c \frac{dh_i(t)}{dt} = \tilde{h}_i(t) - h_i(t) - \left[e^{h_i(t)} - 1\right]\frac{P_i(t)}{P_{sat}} \tag{1}$$

$$P_{i+1}(t) = e^{h_i(t)} P_i(t) \tag{2}$$

où $\tau_c$ est la durée de vie de la porteuse, $h_i(t)$ est l'exposant instantané du gain, $\tilde{h}_i(t)$ est l'exposant instantané du gain de petit-signal, et $P_{sat}$ est la puissance de saturation. Nous supposons que tous les SOA ont la même durée de vie de la porteuse à la puissance de saturation.

L'exposant instantané du gain de petit-signal et le courant électrique de chaque étage sont reliés par l'équation suivante :

$$\tilde{h}_i(t) = CI_i(t) + D$$

où $C = \dfrac{a}{eVI_0}$, et $D = -\dfrac{a}{eV}$, $a$ est le coefficient de gain différentiel, $e$ est la charge de l'électron, $V$ est le volume de gain actif du SOA, et $I_0$ est le courant de transparence du SOA.

Nous écrivons les exposants de gain, les exposants de gain de petit-signal et les puissances optiques comme la somme de leurs valeurs moyennes et de leurs fluctuations autour de zéro :

$$\begin{aligned}
h_i(t) &= \overline{h_i} + \delta h_i(t) \\
\tilde{h}_i(t) &= \overline{\tilde{h}_i} + \delta \tilde{h}_i(t) \\
P_i(t) &= \overline{P_i} + \delta P_i(t)
\end{aligned} \tag{3}$$

On notera que :

$$\begin{aligned}
\overline{\tilde{h}_i} &= C_i \overline{I_i} + D_i \\
\delta \tilde{h}_i(t) &= \delta I_i(t)
\end{aligned} \tag{4}$$

où les symboles notés avec une barre au-dessus sont des valeurs moyennes.

Nous remplaçons (3) dans (1) et (2), et séparons les termes DC et les termes du premier ordre. De plus on transforme les équations vers le domaine de fréquence.

Les équations DC donnent :

$$\frac{\overline{\overline{h}}_i - \overline{h}_i}{e^{\overline{h}_i} - 1} = \frac{\overline{P}_i}{P_{sat,i}}$$

(5)

Les termes petit-signal, en ne conservant que les termes du premier ordre, donnent :

$$j\omega\tau_c \delta H_i(\omega) + a_i \delta H_i(\omega) = \delta\tilde{H}_i(\omega) + b_i \delta\tilde{P}_i(\omega)$$
$$\delta P_{i+1}(\omega) = c_i \delta H_i(\omega) + d_i \delta\tilde{P}_i(\omega)$$
$$i = 1,\ldots,N$$

(6)

où $\delta H_i(\omega)$ est la transformée de Fourier de $\delta h_i(t)$, $\tilde{H}_i(\omega)$ est la transformée de Fourier de $\delta\tilde{h}_i(t)$, et $\delta P_i(\omega)$ est la transformée de Fourier de $\delta P_i(t)$.

Les autres coefficients (5) sont calculés comme suit :

$$a_i = e^{\overline{h}_i} \frac{\overline{P}_i}{P_{sat,i}} + 1$$
$$b_i = -\frac{\left(e^{\overline{h}_i} - 1\right)}{P_{sat,i}}$$
$$c_i = e^{\overline{h}_i} \frac{\overline{P}_i}{P_{sat,i}}$$
$$d_i = e^{\overline{h}_i}$$

(7)

La réponse d'un SOA à deux sections peut être simplement décrite comme étant la combinaison de la réponse de deux SOA séparés.

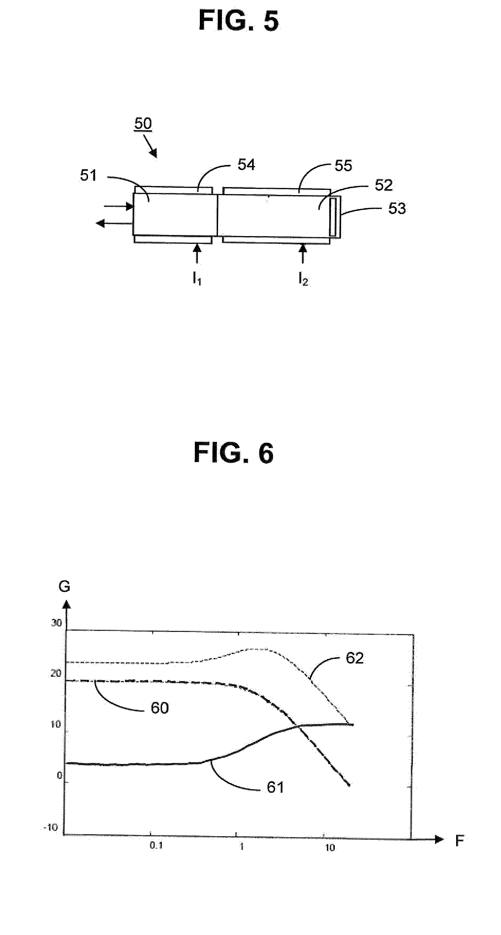

Nous proposons d'utiliser un RSOA **50** comprenant au moins deux sections comme illustré sur la figure 5. Une première section **51** reçoit une puissance optique d'entrée $P_1$ constante et le courant continu $I_1$ en entrée est modulé, tandis qu'une deuxième section **52** reçoit une puissance optique d'entrée $P_2$ modulée et le courant continu $I_2$ d'entrée est constant.

Chaque courant $I_1$ et $I_2$ est modulé. On a donc une valeur moyenne de $I_1$ et de $I_2$ et autour de ce courant moyen il existe une modulation plus ou moins grande :

$$I_i(t) = \overline{I}_i + \delta I_i(t)$$

L'extrémité opposée aux ports d'entrée et de sortie est revêtue d'une surface réfléchissante **53**. La première section **51** se comporte comme un filtre passe-bas et la seconde section **52** se comporte comme un filtre passe-haut.

Dans le mode de réalisation illustré ici, la première section **51** (où l'amplification du signal est effectuée) est plus courte que la deuxième section **52** (où la modulation du signal optique modulé est effectuée). En outre, l'électrode d'amplification **54** a une plus petite surface que l'électrode de modulation **55**.

Les RSOA sont des cas particulier dérivés à partir d'amplificateur optique à semiconducteur SOA standards ; en conséquence, ils bénéficient des améliorations apportées aux SOA ce qui conduit à de faibles coûts de fabrication avec une fiabilité et une reproductibilité assurées. L'utilisation d'une configuration bi-électrode améliore le comportement dynamique des RSOA.

Les réponses en modulation E/O de chacune des deux sections du 2S-RSOA sont illustrées sur la figure 6 : la courbe **60** correspond à la première section **51** qui se comporte comme un filtre passe-bas et la seconde section **52** représentée par la courbe **61** se comporte comme un filtre passe-haut. La courbe **62** représente la réponse totale du RSOA **50** à deux sections. La combinaison des courbes **60** et **61** représentée par la courbe **62** permet d'augmenter la bande passante E/O totale. Cependant, dans le cas d'une modulation large-signal, le courant $I_1$ modulé entrant dans la première section varie et il est difficile d'atteindre un débit de 10 Gbits/s.

Des conditions opératoires spécifiques sont alors nécessaires afin de maintenir une bande passante E/O élevée. Considérant un RSOA comprenant au moins deux sections, la relation suivante est imposée entre les courants d'entrée I$_1$ et I$_2$ modulés dans chacune des deux sections :

$$\delta\tilde{H}_2(\omega) = -\eta\,\delta\tilde{H}_1(\omega) \qquad\qquad (8)$$

dans laquelle $\tilde{H}_1(\omega)$ et $\tilde{H}_2(\omega)$ sont les transformées de Fourier des exposants instantanés du gain de petit-signal $\delta\tilde{h}_1(t)$ et $\delta\tilde{h}_2(t)$ respectivement, et $\eta$ est un coefficient caractérisant le rapport d'amplitude entre ces transformées de Fourier. Les transformées de Fourier étant reliées aux modulations du courant d'amplification I$_1$ et du courant de modulation I$_2$ respectivement par la relation :

$$\delta\tilde{h}_i(t) = \delta I_i(t)$$

La réponse globale de fréquence électro-optique devient :

$$H(\omega) = \frac{\delta P_3(\omega)}{\delta\tilde{H}_1(\omega)} = \frac{1}{C}\,\frac{j\omega\tau_c\big(d_2 c_1 - \eta c_2\big) + a_2 d_2 c_1 - \eta a_1 c_2}{\big(j\omega\tau_c + a_1\big)\big(j\omega\tau_c + a_1\big)} \qquad\qquad (9)$$

On peut en déduire les conditions nécessaires pour permettre de maintenir une haute bande passante de modulation E/O sous différents courants d'entrée correspondant à une modulation de large-signal.

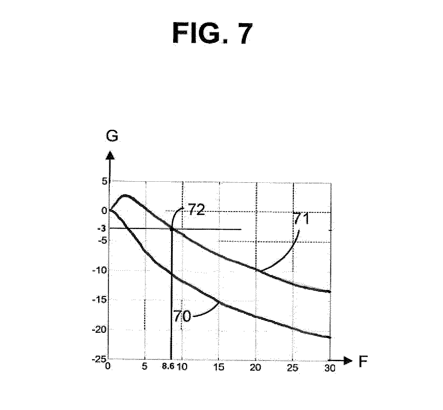

La figure 7 illustre la réponse E/O 70 d'un SOA classique à une seule section sous une modulation petit-signal et la réponse E/O 71 d'un SOA à deux sections, tel qu'illustré sur la figure 5, sous une modulation petit-signal en fonction de la fréquence.

Considérons un courant moyen de polarisation I$_1$ de 70 mA dans la première section 51, par conséquent pour obtenir une large bande passante de modulation E/O, la deuxième section 52 a besoin d'une polarisation I$_2$ moindre, à 21,4 mA par exemple permettant d'atteindre une bande passante de 8,6 GHz. Cette valeur de bande passante 72 est suffisante pour transmettre un signal OOK de 10 Gbit/s, en considérant qu'un minimum de bande passante E/O de 7 GHz est nécessaire, comme indiqué sur la figure 7.

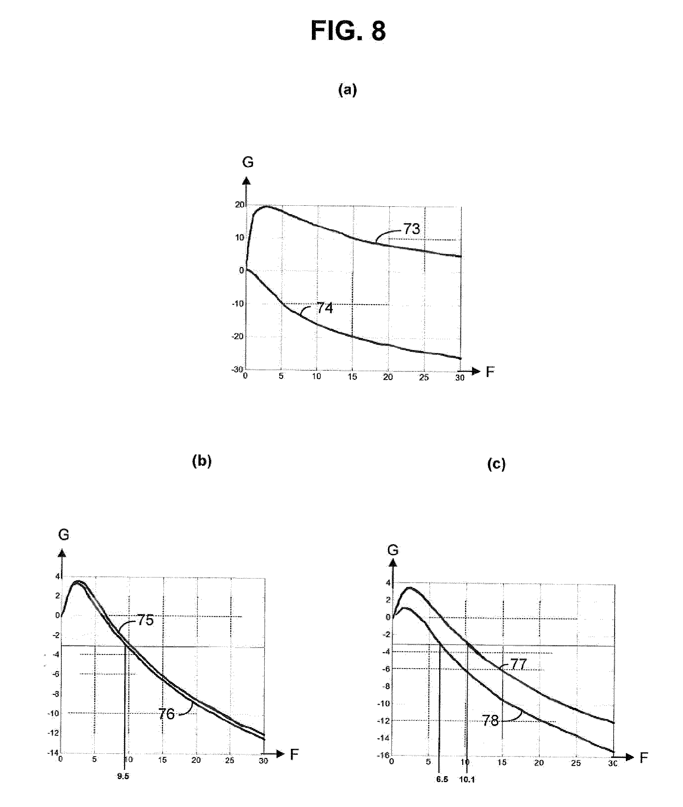

Cependant, la bande passante E/O est fortement affectée quand une modulation est appliquée, même en respectant la relation précédente (8) entre les deux courants électriques d'entrée I$_1$ et I$_2$. La figure 8a montre la bande passante de modulation d'un RSOA à deux sections.

Par exemple une modulation de 20mA est imposée autour de la valeur de polarisation. La modulation des données est appliquée sur la première section (I$_1$ est modulé entre 60mA et 80mA) et sur la deuxième section on applique un courant constant I$_2$ (I$_2$ ~ 21mA). La courbe 73 correspond à un courant I$_1$ = 60mA et la courbe 74 correspond à un courant I$_1$ = 80mA. La bande de modulation est clairement perturbée par la modulation des données par le courant I$_1$. A fort courant (I$_1$ = 80mA), la bande passante s'effondre (~ 2 GHz) et une transmission de données à 10 Gbit/s n'est donc plus possible.

A courant de polarisation élevé, la résonance n'est pas satisfaite et la bande passante E/O diminue fortement. Au contraire, à faible courant de polarisation, la résonance est trop forte ce qui va fortement perturber la porteuse optique (à 0 GHz) qui sera effacée en raison de l'absence d'amplification comparativement à l'autre fréquence. Ensuite, le deuxième niveau de polarisation (correspondant à la seconde électrode) est ajusté selon cette méthode afin de conserver une bande passante E/O élevée.

En utilisant cette méthode, une bande passante E/O au-dessus de 9,5 GHz peut être obtenue comme le montre la figure 8b sur laquelle la courbe 75 correspond à des courants I$_1$ = 60mA et I$_2$ = 21,9mA et la courbe 76 correspond à des courants I$_1$ = 80mA et I$_2$ = 21,07mA. La première électrode est modulée avec les données a transmettre par l'injection du courant I$_1$ qui est modulé entre 60mA et 80mA, donc avec une profondeur de modulation de 20mA autour d'une valeur moyenne de 70mA. Afin de conserver une bande passante de modulation élevée, une modulation complémentaire est imposée à l'électrode de la deuxième section, qui précédemment recevait un courant I$_2$ constant, avec une amplitude et une valeur moyenne différentes. Comme illustré sur la figure 8b, le courant I$_2$ est modulé entre 21,07mA et 21,9mA, soit une profondeur de modulation de 0,83mA et une valeur moyenne de 21,485mA.

Cette différence de profondeur de modulation est caractérisee par le coefficient $\eta$ qui détermine le rapport entre les deux transformées de Fourier $\delta\tilde{H}_1(\omega)$ et $\delta\tilde{H}_2(\omega)$ relatives aux courants I$_1$ et I$_2$ respectivement :

$$\delta\tilde{H}_2(\omega) = -\eta\,\delta\tilde{H}_1(\omega)$$

Toutefois ces valeurs de courant sont difficilement atteignables en pratique car une précision de 0,01 mA est alors requise, et un compromis peut se révéler nécessaire entre d'une part la variation de la bande passante et d'autre part la stabilité et la précision des sources de courant.

Par exemple, en considérant un pas minimum de 0,1 mA entre les courants $I_1$ et $I_2$ de polarisation différents, la bande passante E/O varie entre 6,4 GHz et 10,1 GHz comme illustré sur la figure 8c, ce qui est acceptable pour la transmission d'un signal OOK (pour « On-Off Keying » en anglais) à 10 Gbit/s. Sur la figure 8c, la courbe **77** correspond à des cour !!ants $I_1$=60mA et $I_2$=21,9mA et la courbe **78** correspond à des courants $I_1$=80mA et $I_2$=21,1 mA.

## Revendications

1. Procédé de pilotage des courants injectés simultanément respectivement dans chaque section d'un amplificateur optique à semiconducteur SOA comportant au moins une section d'amplification dans laquelle est injecté un courant d'amplification $I_1$ et au moins une section de modulation dans laquelle est injecté un courant de modulation $I_2$, le courant d'amplification $I_1$ et le courant de modulation $I_2$ étant reliés par la relation :

$$\delta\tilde{H}_2(\omega) = -\eta\,\delta\tilde{H}_1(\omega)$$

dans laquelle $\tilde{H}_1(\omega)$ et $\tilde{H}_2(\omega)$ sont les transformées de Fourier des exposants instantanés du gain de petit-signal $\delta\tilde{h}_1(t)$ et $\delta\tilde{h}_2(t)$ respectivement, et $\eta$ est un coefficient caractérisant le rapport d'amplitude entre ces transformées de Fourier, les transformées de Fourier étant reliées aux modulations du courant d'amplification $I_1$ et du courant de modulation $I_2$ respectivement par la relation : $\delta\tilde{h}_i(t) = \delta I_i(t)$.

2. Amplificateur optique à semiconducteur comportant au moins une section d'amplification dans laquelle est injecté un courant d'amplification $I_1$ et au moins une section de modulation dans laquelle est injecté un courant de modulation $I_2$, dans lequel la section de modulation est plus courte que la section d'amplification du signal optique modulé.

3. Amplificateur optique selon la revendication 2, dans lequel l'électrode de la section de modulation a une surface moindre que l'électrode de la section d'amplification.

4. Amplificateur optique selon l'une des revendications 2 et 3, qui est un amplificateur optique à semiconducteur réfléchissant RSOA.

# FIG. 1

# FIG. 2

# FIG. 3

# FIG. 4

# FIG. 5

# FIG. 6

# FIG. 7

# FIG. 8

**(a)**

**(b)**

**(c)**

**Europäisches Patentamt**
**European Patent Office**
**Office européen des brevets**

# RAPPORT DE RECHERCHE EUROPEENNE

Numéro de la demande

EP 14 30 7056

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X<br>A | EP 2 501 000 A1 (ALCATEL LUCENT [FR]) 19 septembre 2012 (2012-09-19)<br>* abrégé; figure 4b *<br>* alinéa [0016] *<br>----- | 2-4<br><br>1 | INV.<br>H01S5/026<br>H01S5/0625<br>H01S5/50 |
| A | DE VALICOURT G ET AL: "Chirp Reduction in Directly Modulated Multi-Electrode RSOA Devices in Passive Optical Networks", IEEE PHOTONICS TECHNOLOGY LETTERS, IEEE SERVICE CENTER, PISCATAWAY, NJ, US, vol. 22, no. 19, 1 octobre 2010 (2010-10-01), pages 1425-1427, XP011507755, ISSN: 1041-1135, DOI: 10.1109/LPT.2010.2062496<br>* abrégé *<br>* le document en entier *<br>----- | 1 | |
| A | HYUN-SOO KIM ET AL: "Improvement of modulation bandwidth in multisection RSOA for colorless WDM-PON", OPTICS EXPRESS, vol. 17, no. 19, 14 septembre 2009 (2009-09-14), page 16372, XP055002993, DOI: 10.1364/OE.17.016372<br>* abrégé *<br>* page 2 part 2 first lines *<br>* page 4  first lines *<br>* le document en entier *<br>----- | 1 | **DOMAINES TECHNIQUES RECHERCHES (IPC)**<br><br>H01S |
| A | EP 2 498 350 A1 (ALCATEL LUCENT [FR]) 12 septembre 2012 (2012-09-12)<br>* ab. fig.3a,3b *<br>----- | 1 | |

Le présent rapport a été établi pour toutes les revendications

| Lieu de la recherche | Date d'achèvement de la recherche | Examinateur |
|---|---|---|
| Munich | 3 juillet 2015 | Lendroit, Stéphane |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 14 30 7056

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-07-2015

| Document brevet cité au rapport de recherche | Date de publication | Membre(s) de la famille de brevet(s) | Date de publication |
|---|---|---|---|
| EP 2501000 A1 | 19-09-2012 | AUCUN | |
| EP 2498350 A1 | 12-09-2012 | AUCUN | |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- EP 2501000 A